# EUROPÄISCHE PATENTSCHRIFT

(11) **EP 0 730 275 B1**
(45) Veröffentlichungstag und Bekanntmachung des Hinweises auf die Patenterteilung: **26.06.2002**
(21) Anmeldenummer: 96103201.8
(22) Anmeldetag: 01.03.1996
(51) Int. Cl.: G11C 5/14

(54) **Platine mit mehreren integrierten Schaltungen**
Printed circuit board comprising a plurality of integrated circuits
Platine de circuit imprimé comportant plusieurs circuits intégrés

(30) Priorität: 03.03.1995 DE 19507571
(43) Veröffentlichungstag der Anmeldung: 04.09.1996
(73) Patentinhaber: Infineon Technologies AG, 81669 München (DE)
(72) Erfinder: von der Ropp, Thomas, Dr. Dipl.-Phys., 82110 Germering (DE)
(74) Vertreter: Kottmann, Heinz Dieter, Dipl.-Ing.

(56) Entgegenhaltungen:
- EP-A- 0 640 974
- GB-A- 2 258 925
- US-A- 4 658 151
- ELECTRONICS INTERNATIONAL (8032), Bd. 55, Nr. 3, 1982, XP002115057 New York

## Beschreibung

Die Erfindung betrifft eine Platine mit mehreren integrierten Schaltungen gemäß dem Oberbegriff des Anspruchs 1.

Da sie eine geringere Leistungsaufnahme haben, kommen zunehmend integrierte Schaltungen (ICs) zum Einsatz, welche mit einer niedrigeren Versorgungsspannung betrieben werden als herkömmliche ICs. Beispielsweise werden neuere Generationen von CMOS-Bausteinen mit 3,3 V statt mit 5 V versorgt.

Bisher muß Platinen, welche mit ICs bestückt sind, diejenige Versorgungsspannung zugeführt werden, welche die auf der Platine montierten ICs benötigen. Wenn ein Anwender z.B. eine Platine in einer 5 V-Umgebung einsetzen möchte, müssen die auf der Platine befindlichen ICs ebenfalls mit 5 V versorgbar sein. Entsprechendes gilt für andere Versorgungsspannungen.

Einerseits besteht, abhängig von der Umgebung, in der eine Platine eingesetzt werden soll, der Bedarf sowohl nach Platinen, die mit niedriger Versorgungsspannung versorgt werden können, als auch nach solchen, die mit hoher Versorgungsspannung versorgt werden können. Es liegt andererseits im Interesse eines Herstellers von mit ICs bestückten Platinen sowie der Zulieferer und Hersteller der entsprechenden ICs, möglichst nur ICs vom selben Typ einzusetzen bzw. anbieten zu müssen, die mit derselben Versorgungsspannung versorgbar sind. Für diese Interessengruppen ließe sich dann der Aufwand der Lagerhaltung reduzieren, für den IC-Hersteller ergäbe sich insbesondere der Vorteil, für ein und denselben Grundtypen von ICs nicht verschiedene Varianten entwickeln zu müssen, die sich im wesentlichen lediglich durch ihre Versorgungsspannung voneinander unterscheiden. Diese Problematik stellt sich insbesondere den Herstellern von sogenannten Modulplatinen, welche mit gleichartigen Speicherbausteinen, z.B. DRAMs, bestückt sind, und deren Zulieferern bzw. den IC-Herstellern.

Aus der US-A-4 658 151 ist eine Speicherplatine mit Pufferbatterie bekannt.

Der Erfindung liegt daher die Aufgabe zugrunde, eine Platine mit mehreren integrierten Schaltungen, die mit einer ersten Versorgungsspannung arbeiten, zu schaffen, welche mit einer zweiten Versorgungsspannung versorgbar ist, die von der ersten Versorgungsspannung abweichen kann.

Diese Aufgabe wird durch eine Platine gemäß dem Anspruch 1 gelöst.

Mit der erfindungsgemäßen Platine wird der Einsatz von ICs möglich, die eine andere Versorgungsspannung erfordern, als zur Versorgung der Platine zur Verfügung steht.

Die Potential-Anpassungsanordnung kann beispielsweise entweder ein Spannungsregler oder eine Diode sein.

Die Potential-Anpassungsanordnung ist überbrückbar; dadurch kann auch nach der Herstellung der Platine noch festgelegt werden, ob sie mit einer von der ersten Versorgungsspannung abweichenden oder mit dieser übereinstimmenden zweiten Versorgungsspannung versorgt wird.

Es kann außerdem vorgesehen werden, daß die Potential-Anpassungsanordnung deaktivierbar ist. In Verbindung mit der Überbrückung kann dann auch eine Deaktivierung der Potential-Anpassungsanordnung vorgenommen werden, so daß diese das erste Versorgungspotential nicht mehr beeinflußt. Die gleichzeitige Überbrückung und Deaktivierung empfiehlt sich beispielsweise, wenn die Potential-Anpassungsanordnung ein Spannungsregler ist.

Schaltungen, die die Deaktivierung und die Überbrückung ermöglichen, sind dem Fachmann bekannt. Sie können beispielsweise Fuses, Antifuses und/oder Transistoren aufweisen, die als entsprechende Schalter fungieren. In letzterem Fall wäre die Deaktivierung und Überbrückung reversibel, so daß die Platine ständig an verschiedene Versorgungsspannungen anpaßbar ist.

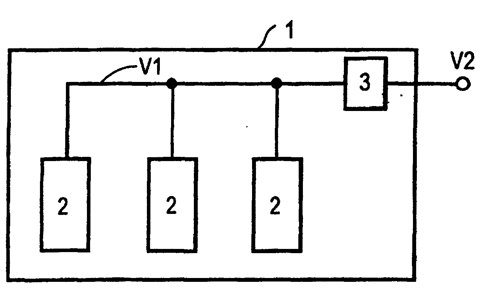

Die Erfindung wird im folgenden anhand des in der Figur dargestellten Ausführungsbeispiels beschrieben.

Die Figur zeigt eine Platine 1, auf der mehrere integrierte Schaltungen 2 montiert sind, die mit einem ersten Versorgungspotential V1 arbeiten. Das erste Versorgungspotential V1 wird ihnen als Ausgangspotential einer Potential-Anpassungsanordnung 3 zugeführt. Ein Eingangspotential der Potential-Anpassungsanordnung 3 ist ein der Platine zuführbares, zweites Versorgungspotential V2.

Besonders einfach läßt sich die Potential-Anpassungsanordnung 3 durch einen Spannungsregler realisieren. Dieser kann - je nachdem, ob das erste Versorgungspotential V1 größer oder kleiner als das zweite Versorgungspotential V2 ist - entweder eine Erhöhung oder eine Erniedrigung des zweiten Versorgungspotentials V2 vornehmen. Diese Ausführungsform der Erfindung zeichnet sich dadurch aus, daß Schwankungen des zweiten Versorgungspotentials V2 durch den Spannungsregler 3 unterdrückbar sind und sich somit nicht auf das erste Versorgungspotential V1 auswirken, sofern der Spannungsregler 3 ein stabilisiertes Ausgangspotential liefert.

Ist das erste Versorgungspotential V1 kleiner als das zweite Versorgungspotential V2, kann die Potential-Anpassungsanordnung 3 mindestens eine in Durchlaßrichtung betriebene Diode aufweisen, an welcher eine Spannung abfällt, welche der Differenz zwischen den beiden Versorgungspotentialen V1, V2 entspricht.

Das erste Versorgungspotential, mit dem die integrierten Schaltungen 1 versorgt werden, muß zur Gewährleistung ihrer ordnungsgemäßen Funktion bestimmte Spezifikationen erfüllen. Da relative Schwankungen des zweiten Versorgungspotentials V2, beispielsweise, wenn die Potential-Anpassungsanordnung 3 eine Diode ist, größere relative Schwankungen des ersten Versorgungspotentials V1 zur Folge haben können, muß gegebenenfalls eine Anpassung der Spezifikation für das zweite Versorgungspotential V2 der Platine vorgenommen werden.

## Patentansprüche

1. Platine mit mehreren integrierten Schaltungen (2), die mit einem zuführbaren ersten Versorgungspotenzial (V1) betreibbar sind, und mit einer Potenzial-Anpassungsanordnung (3), deren Ausgangspotenzial das erste Versorgungspotenzial (V1) ist und deren Eingangspotenzial ein der Platine (1) zuführbares zweites Versorgungspotenzial (V2) ist,
**dadurch gekennzeichnet, dass**
die Platine die Potenzial-Anpassungsanordnung (3) aufweist, welche eine aktivierbare Überbrückungseinrichtung aufweist, die im aktiven Zustand die übrigen Teile der Potenzial-Anpassungsanordnung (3) überbrückt, sodass das erste Versorgungspotenzial (V1) gleich dem jeweils angelegten zweiten Versorgungspotenzial (V2) ist.

2. Platine nach Anspruch 1,
**dadurch gekennzeichnet, dass**
die integrierten Schaltungen (2) Speicherbausteine sind.

3. Platine nach Anspruch 1,
**dadurch gekennzeichnet, dass**
die Potenzial-Anpassungsanordnung (3) wenigstens eine in Durchlassrichtung betriebene Diode aufweist.

4. Platine nach einem der Ansprüche 1 bis 3,
**dadurch gekennzeichnet, dass**
die Potenzial-Anpassungsanordnung (3) ein Spannungsregler ist.

5. Platine nach einem der Ansprüche 1 bis 4,
**dadurch gekennzeichnet, dass**
die Potenzial-Anpassungsanordnung (3) deaktivierbar ist.

## Claims

1. Circuit board having a plurality of integrated circuits (2), which can be operated with a first supply potential (V1) that can be fed, and having a potential matching arrangement (3), whose output potential is the first supply potential (V1) and whose input potential is a second supply potential (V2) that can be fed to the circuit board (1),
**characterized**
**in that** the circuit board has the potential matching arrangement (3) which has an activatable bridging device which, in the active state, bridges the remaining parts of the potential matching arrangement (3), so that the first supply potential (V1) is equal to the respectively applied second supply potential (V2).

2. Circuit board according to Claim 1,
**characterized**
**in that** the integrated circuits (2) are memory modules.

3. Circuit board according to Claim 1,
**characterized**
**in that** the potential matching arrangement (3) has at least one diode which is operated in the forward direction.

4. Circuit board according to one of Claims 1 to 3,
**characterized**
**in that** the potential matching arrangement (3) is a voltage regulator.

5. Circuit board according to one of Claims 1 to 4,
**characterized**
**in that** the potential matching arrangement (3) can be deactivated.

## Revendications

1. Platine comportant plusieurs circuits (2) intégrés, qui peuvent être mis à un premier potentiel (V1) d'alimentation qu'on peut leur appliquer et un dispositif (3) d'adaptation de potentiel, dont le potentiel de sortie est le premier potentiel (V1) d'alimentation et dont le potentiel d'entrée est un deuxième potentiel (V2) d'alimentation que l'on peut appliquer à la platine (1),
**caractérisée en ce que**
la platine comporte le dispositif (3) d'adaptation de potentiel, qui a un dispositif de shuntage qui peut être activé et qui, à l'état actif, shunte les autres parties du dispositif (3) d'adaptation de potentiel, de sorte que le premier potentiel (V1) d'alimentation soit égal au deuxième potentiel (V2) d'alimentation appliqué respectivement.

2. Platine suivant la revendication 1, **caractérisée en ce que** les circuits (2) intégrés sont des modules de mémoire.

3. Platine suivant la revendication 1, **caractérisée en ce que** le dispositif (3) d'adaptation de potentiel a au moins une diode fonctionnant en sens passant.

4. Platine suivant l'une des revendications 1 à 3, **caractérisée en ce que** le dispositif (3) d'adaptation de potentiel est un régulateur de tension.

5. Platine suivant l'une des revendications 1 à 4, **caractérisée en ce que** le dispositif (3) d'adaptation de potentiel peut être désactivé.
